# EUROPEAN PATENT APPLICATION

(11) **EP 2 221 882 A2**
(43) Date of publication of application: **25.08.2010**
(21) Application number: 10153442.8
(22) Date of filing: 12.02.2010
(51) Int. Cl.: H01L 31/052

(54) **Solar concentrator comprising two solar cells**

(30) Priority: 20.02.2009 TW 098105433; 08.04.2009 TW 098111674
(71) Applicant: Aussmak Optoelectronics Corp., Tainan County 710 (TW)
(72) Inventor: Lin, Chung-Jyh, 710, YongKang City, Tainan County (TW)
(74) Representative: 2K Patentanwälte Blasberg Kewitz & Reichel

(57) **Abstract**

A solar cell which receives an incident light includes a first solar cell element, a second solar cell element and a light-concentrating element. The area of the first solar cell element is smaller than that of the second solar cell element. The second solar cell element is disposed in neighbor to the first solar cell element or the light-concentrating element. At least one portion of energy of the incident light is concentrated to the first solar cell element through the light-concentrating element, and another portion of the energy of the incident light is absorbed by the second solar cell element.

## Description

### BACKGROUND OF THE INVENTION

### Field of Invention

The invention relates to a cell and, in particular, to a solar cell.

### Related Art

Solar energy does not cause environmental pollution and is easily acquired and never exhausted, becoming an important resource of alternative energy. The solar cell (photovoltaic) utilizing solar energy is a kind of photoelectric converting device, which converts solar energy to electric energy after illuminated by sun's rays.

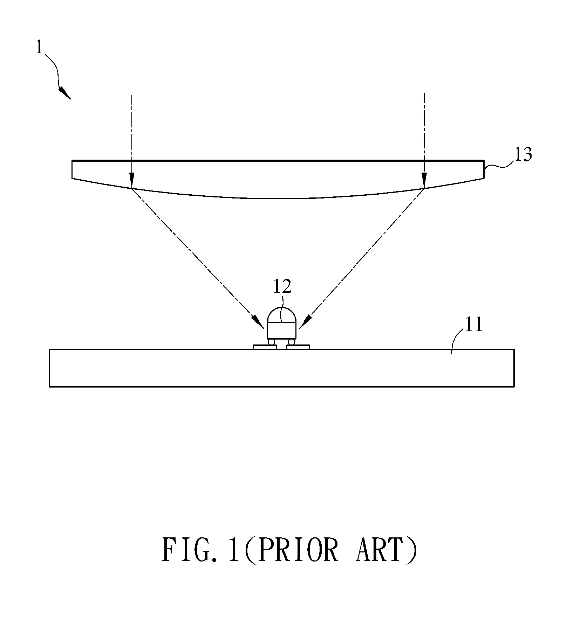

To improve power generation efficiency, a concentrating photovoltaic (CPV) is developed recently. As shown in FIG. 1, a conventional CPV 1 includes a substrate 11, a solar cell package 12 and a concentrating lens 13. The solar cell package 12 is disposed on the substrate 11, and the concentrating lens 13 is disposed opposite to the substrate 11. The light is concentrated to the solar cell package 12 when passing through the concentrating lens 13, and thus is intensified. Besides, the level of intensification of the light is determined by the magnitude of magnification of the concentrating lens 13. Hence, because the solar cell package 12 absorbs the intensified light, efficiencies of photoelectric converting and power generating are improved.

However, most light rays will be scattered by clouds and mist in the bad weather condition, and scattered light rays are not parallel light, so they can not be concentrated to the solar cell package 12 through the concentrating lens 13, as a result of decreasing photoelectric converting efficiency. On the other hand, sunlight has a widespread spectrum, while the solar cell package 12 can only accept the light having a certain range of wavelength, so that the utility rate of light is very poor and therefore the photoelectric converting efficiency of the CPV 1 can not be improved.

Therefore, it is an important subject to provide a solar cell that can adapt to various weather conditions, and accept the light of various wave bands, thereby improving photoelectric converting efficiency.

### SUMMARY OF THE INVENTION

In view of the foregoing subject, an object of the invention is to provide a solar cell that can adapt to various weather conditions, and accept the light of various wave bands, thereby improving photoelectric converting efficiency.

To achieve the above object, the invention discloses a solar cell receiving an incident light and including a first solar cell element, a second solar cell element and a light-concentrating element. The area of the first solar cell element is smaller than that of the second solar cell element. The second solar cell element is disposed in neighbor to the first solar cell element or the light-concentrating element. At least one portion of energy of the incident light is concentrated to the first solar cell element through the light-concentrating element, and another portion of the energy of the incident light is absorbed by the second solar cell element.

As mentioned above, the solar cell of the invention includes two types of solar cell elements, wherein at least one portion of energy of the incident light is concentrated to the smaller first solar cell element, while another portion of the energy of the incident light can be absorbed by the second solar cell element. In good weather condition, most light rays are parallel light and are thus concentrated to the first solar cell element by the light-concentrating element to obtain higher concentrating effect and photoelectric converting efficiency. In bad weather condition, most light rays are scattered and thus not easy to be concentrated to the first solar cell element after passing through the light-concentrating element, but they can still be absorbed by the larger second solar cell element, thereby improving the photoelectric converting efficiency. In addition, when the first and second solar cell elements are made of different materials, they can absorb the light with different wave bands, thereby enhancing the light usage and photoelectric converting efficiency.

### BRIEF DESCRIPTION OF THE DRAWINGS

The invention will become more fully understood from the detailed description and accompanying drawings, which are given for illustration only, and thus are not limitative of the present invention, and wherein:

FIG. 1 is a schematic diagram of a conventional CPV;

FIG. 2 is a schematic view of the solar cell according to a first embodiment of the invention;

FIG. 3 is a schematic view of the solar cell according to a second embodiment of the invention;

FIG. 4 is a schematic view of the solar cell according to a third embodiment of the invention;

FIG. 5 is a schematic view of the solar cell according to a fourth embodiment of the invention;

FIG. 6 is a schematic view of the solar cell according to a fifth embodiment of the invention;

FIG. 7 is a schematic view of the solar cell according to a sixth embodiment of the invention;

FIG. 8 is a schematic view of the solar cell according to a seventh embodiment of the invention;

FIG. 9 is a schematic view of the solar cell according to a eighth embodiment of the invention;

FIG. 10 is a schematic view of the solar cell according to a ninth embodiment of the invention;

FIG. 11 is a schematic view of the solar cell according to a tenth embodiment of the invention;

FIG. 12 is a schematic view of the solar cell according to a eleventh embodiment of the invention;

FIG. 13 is a schematic view of the solar cell according to a twelfth embodiment of the invention;

FIG. 14 is a schematic view of the solar cell according to a thirteenth embodiment of the invention;

FIG. 15 is a schematic view of the solar cell according to a fourteenth embodiment of the invention;

FIG. 16 is a schematic view of the solar cell according to a fifteenth embodiment of the invention;

FIG. 17 is a schematic view of the solar cell according to a sixteenth embodiment of the invention;

FIG. 18 is a schematic view of the solar cell according to a seventeenth embodiment of the invention;

FIGs. 19A to 19C are schematic views of the solar cell according to a eighteenth embodiment of the invention;

FIG. 20 is a schematic view of the solar cell according to a nineteenth embodiment of the invention;

FIG. 21 is a schematic view of the solar cell according to a twentieth embodiment of the invention; and

FIG. 22 is a schematic view of another aspect of the solar cell according to the twentieth embodiment of the invention.

### DETAILED DESCRIPTION OF THE INVENTION

The present invention will be apparent from the following detailed description, which proceeds with reference to the accompanying drawings, wherein the same references relate to the same elements.

### First embodiment

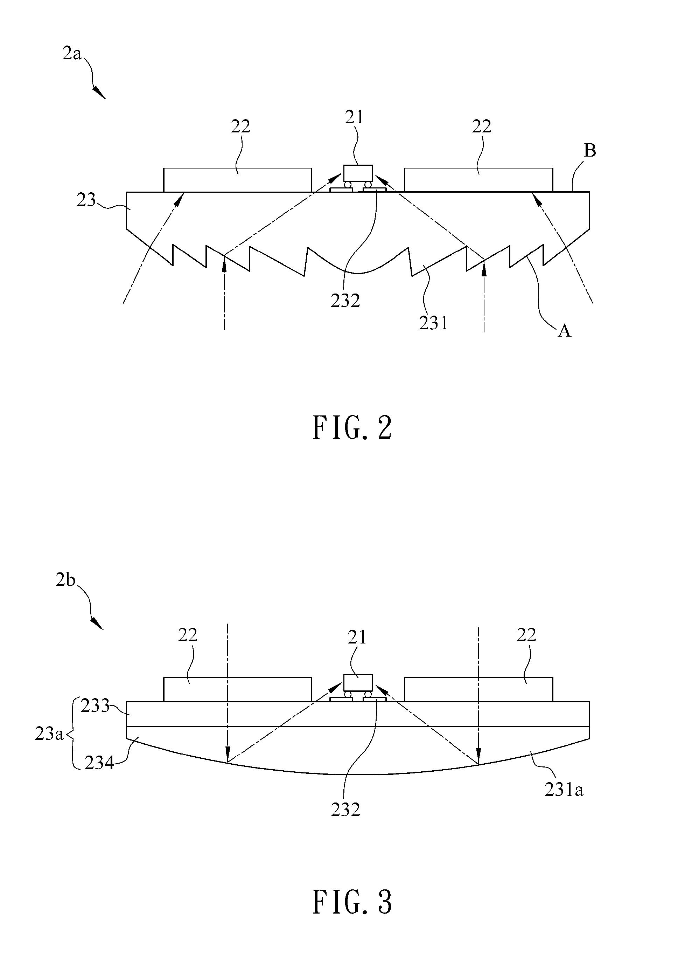

As shown in FIG. 2, a solar cell 2a according to the first embodiment of the invention includes a first solar cell element 21, a second solar cell element 22 and a light-concentrating element 23. The area of the first solar cell element 21 is smaller than that of the second solar cell element 22. In the embodiment, the area of the first solar cell element 21 is smaller than half that of the second solar cell element 22.

In the embodiment, the first solar cell element 21 is disposed on the light-concentrating element 23. The first solar cell element 21 can be a die or a package, and is unlimited in shape, such as a square, a circle or a strip. If the first solar cell element 21 is a die, it can be disposed on the light-concentrating element 23 by wire bonding and/or flip-chip bonding. If the first solar cell element 21 is a package, it can be disposed on the light-concentrating element 23 by SMT (surface mount technology). The first solar cell element 21 of the embodiment is, for example, a die and flip-chip bonded on the light-concentrating element 23. Besides, the first solar cell element 21 can be flip-chip bonded on the light-concentrating element 23 by laser welding (laser rays can pass through the light-concentrating element 23 before welding). In this case, because wire bonding is not utilized and the hot spot of laser is smaller (for example, its diameter can be 3µm), light-absorption area can be greatly increased and proportion of the light-absorption area can be enlarged as the die is smaller.

The material of the first solar cell element 21 can include mono-crystalline silicon, multi-crystalline silicon, amorphous silicon, micro-crystalline silicon, compound semiconductor or organic material. For example, the first solar cell element 21 can be a mono-crystalline silicon solar cell die, a multi-crystalline silicon solar cell die, an amorphous silicon solar cell die, a III-V solar cell die, a II-VI solar cell die or an organic solar cell die.

The second solar cell element 22 can be disposed in neighbor to the first solar cell element 21 or the light-concentrating element 23. In the embodiment, the second solar cell element 22 is disposed adjacent to and around the first solar cell element 21, and disposed adjacent to and on a surface of the light-concentrating element 23.

In the embodiment, the second solar cell element 22 is a thin film solar cell. The material of the second solar cell element 22 can include amorphous silicon, compound semiconductor, organic material, micro-crystalline silicon, or poly silicon. The second solar cell element 22 is unlimited in shape, such as a strip, a circle or a loop. The first solar cell element 21 and the second solar cell element 22 can be made of the same material or different materials. When both of them are made of different materials, they can absorb the light of different wave bands. For example, pure amorphous silicon material can absorb the light of shorter wavelength (the energy level is from 1.7eV to 1.8eV), while pure amorphous silicon material doped with Ge can absorb longer wavelength (the energy level is from 1.4eV to 1.6eV), and these two types can be applied to the first and second solar cell elements 21, 22, respectively. In the embodiment, the first solar cell element 21 can include, for example, multi-crystalline silicon, mono-crystalline silicon, GaAs, CIGS, or CIS (CuInSe), while the second solar cell element 22 can include, for example, amorphous silicon or CIGS.

The light-concentrating element 23 can be a reflective type or a refractive type, and that is, the light can be reflected by or passes through the light-concentrating element 23. In the embodiment, the light-concentrating element 23 has a first surface A and an opposite second surface B, the first surface A has a concentrating structure 231, and the first solar cell element 21 and the second solar cell element 22 are disposed adjacent (directly or indirectly) to the second surface B. The first solar cell element 21 and the second solar cell element 22 are disposed at the second surface B, as an illustrative example. Besides, a circuit layer 232 is disposed on the second surface B, and the first solar cell element 21 and the second solar cell element 22 are electrically connected to the circuit layer 232. The concentrating structure 231 can have at least a Fresnel structure, at least a lens, a plurality of prisms or a reflective mirror, and the Fresnel structure is illustrated as an example. The amount of the concentrating structure 231 can correspond to that of the first and second solar cell elements 21, 22, and, for example, they can be arranged by one-to-one.

The solar cell receives an incident light, and at least one portion of energy of the incident light is concentrated to the first solar cell element 21 through the light-concentrating element 23, while another portion of the energy of the incident light is absorbed by the second solar cell element 22. Therefore, in good weather condition, most light rays are parallel light, and they can be concentrated to the first solar cell element 21 through the light-concentrating element 23, so as to improve concentrating magnification and photoelectric converting efficiency. In bad weather condition, most light rays are scattered and thus not easy to be concentrated to the first solar cell element 21, but still absorbed by the second solar cell element 22. Accordingly, power generation efficiency of the solar cell 2a can be enhanced with prolonged power generation period. Of course, the better effect can be obtained by cooperating with a solar tracking apparatus.

The embodiment can be configured in various ways by the following illustration.

### Second embodiment

Referring to FIG. 3, the main difference between a solar cell 2b and the solar cell 2a is that the light-concentrating element 23a of the solar cell 2b has a body portion 233 and a concentrating portion 234, and the body portion 233 and the concentrating portion 234 can be integrally formed, adjacently disposed or separated. The light-concentrating element 23 of the solar cell 2a is integrally formed, while the body portion 233 and the concentrating portion 234 of the light-concentrating element 23a are disposed adjacently. In the embodiment, the concentrating structure 231a of the light-concentrating element 23a is a micro-lens, and a reflective layer is disposed at the outer surface of the concentrating structure 231a to reflect light.

When the incident light enters into the solar cell 2b, at least one portion of energy of the incident light is absorbed by the first and second solar cell elements 21, 22, while another portion of the energy is concentrated to the first solar cell 21 to be absorbed through the light-concentrating element 23a.

### Third embodiment

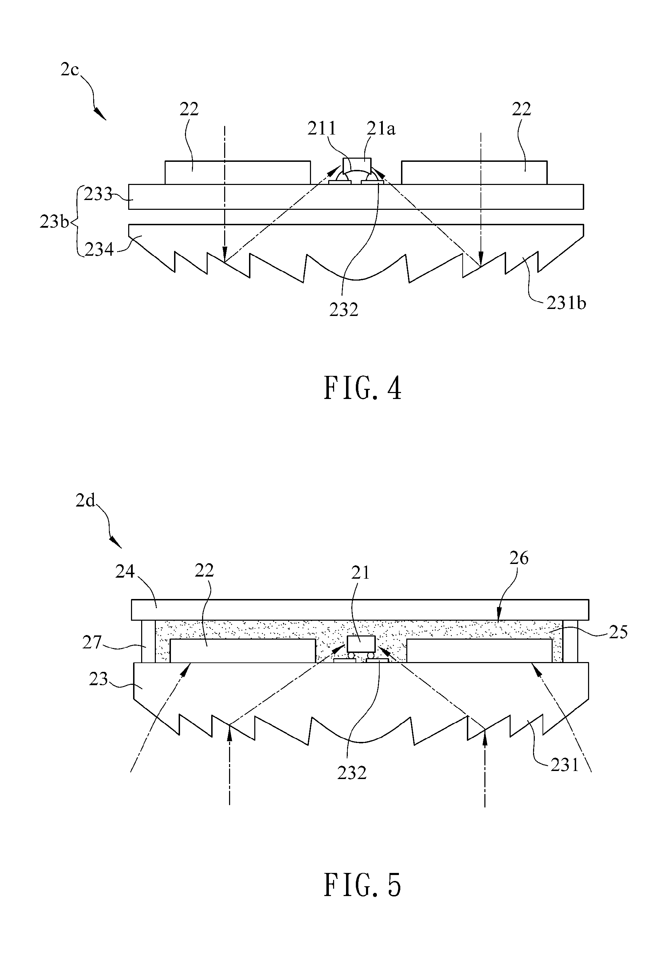

As shown in FIG. 4, the main difference between a solar cell 2c and the solar cell 2b is that the body portion 233 and the concentrating portion 234 of the solar cell 2c are separated, that is a gap is between them. The gap can make the concentrating magnification much higher. Besides, the concentrating structure 231b of the light-concentrating element 23b is a Fresnel structure, and a reflective layer is disposed at the outer surface of which to reflect light. The first solar cell element 21a of the solar cell 2c is a package, and a light-absorption side thereof can have a light-guiding structure, such as a concave or a convex (the concave is illustrated in FIG. 4). The light can be concentrated to the first solar cell element 21a twice through the light-guiding structure.

### Fourth embodiment

Referring to FIG. 5, the main difference between a solar cell 2d and the solar cell 2a is that the solar cell 2d further includes a substrate 24 which is opposite to the light-concentrating element 23, and the first and second solar cell elements 21, 22 are disposed between the substrate 24 and the light-concentrating element 23. The substrate 24 can be light-permeable or not light-permeable. Because the light-concentrating element 23 is a refractive type, the substrate 24 doesn't need to be light-permeable. Besides, the substrate 24 can further comprise a reflective layer to reflect the light that is not absorbed to the first and second solar cell elements 21, 22. In the embodiment, an interval or a chamber is formed between the substrate 24 and the light-concentrating element 23. The chamber 26 is illustrated as an example in FIG. 5, and the chamber 26 can be sealed by a sealing element 27 which can be made, for example, of a colloid or a solid with a functionality of insulation.

The solar cell 2d can further have a liquid 25 which is filled in the interval or the chamber 26. The liquid 25 can include high thermal conductive material, such as silicon oil, glycerin or mesitylene (solvent). The refractive index of the liquid 25 can be closer to that of the substrate 24 and the light-concentrating element 23 (for example, the refractive index of glass is about 1.5) to prevent many times of refraction of light. Of course, the liquid 25 can be adopted according to practical situations in consideration of insulating property, corrosion property, solidification point, and thermal expansion coefficient. The liquid 25 can carry great heat produced by the first and second solar cell elements 21, 22, to improve the heat dissipation efficiency and prolong the lifespan of the solar cell 2d.

### Fifth embodiment

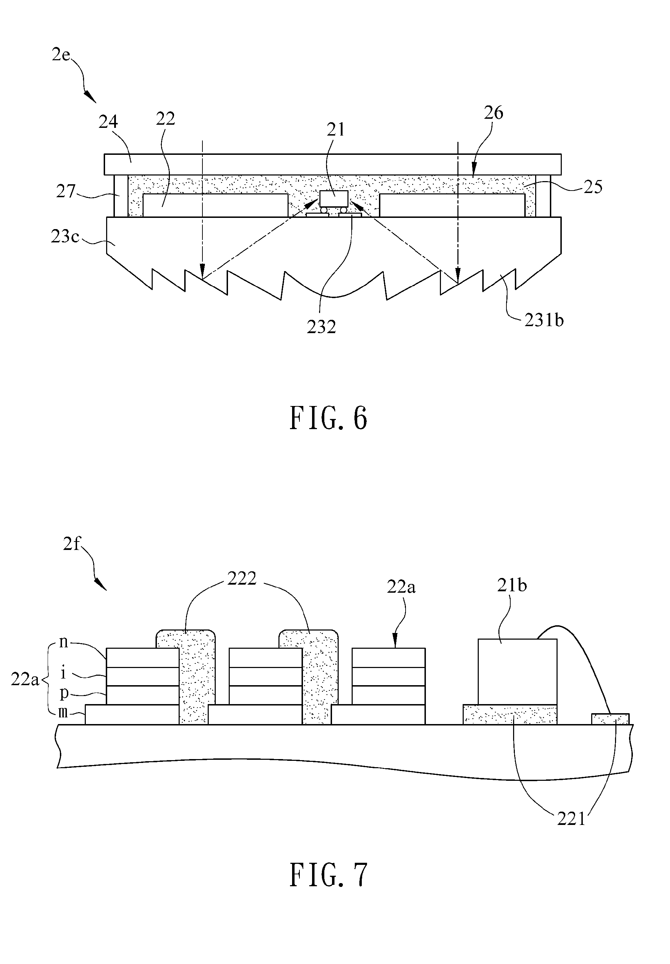

As shown in FIG. 6, the main difference between a solar cell 2e and the solar cell 2d is that the light-concentrating element 23c is a reflective type, and the substrate 24 is at least partially light-permeable.

### Sixth embodiment

FIG. 7 is a partial enlarged diagram of the first and second solar cell elements 21b, 22a of a solar cell 2f. As shown in FIG. 7, when the first and second solar cell elements 21b, 22a are disposed at the same surface, the cost on process can be decreased. The second solar cell element 22a has a first conductive pattern 221 and a second conductive pattern 222 insulated with each other, the first solar cell element 21b transmits electric power through the first conductive pattern 221, and the second solar cell element 22a transmits electric power through the second conductive pattern 222. As the first conductive pattern 221 can be made at the same time when the process of making the metal layer m of the second solar cell element 22a is implemented, the cost on process can be decreased. In the embodiment, the second solar cell element 22a has four layers including an n type layer n, an intrinsic layer i, a p type layer p and the metal layer m.

### Seventh embodiment

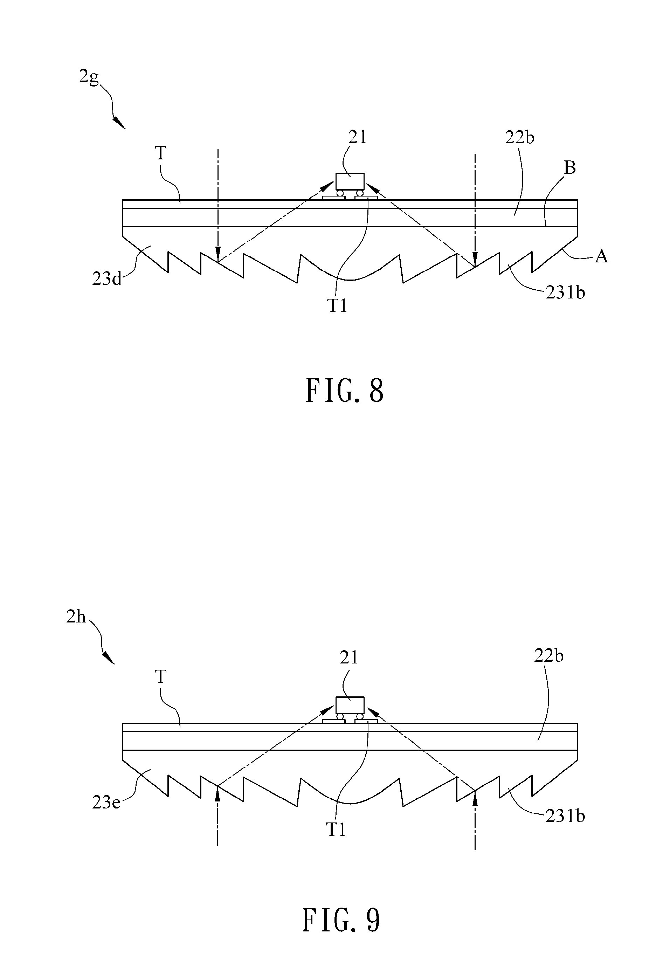

As shown in FIG. 8, the main difference between a solar cell 2g and the solar cell 2a is that the second solar cell element 22b of the solar cell 2g is disposed on the second surface B, and the first solar cell element 21 is disposed to the second solar cell element 22b through a transparent insulating layer T. The transparent insulating layer T has a circuit layer T1 through which the first solar cell element 21 transmits electric power. Besides, the light-concentrating element 23d is a reflective type, and the concentrating structure 231b of which has a reflective layer to reflect light.

### Eighth embodiment

As shown in FIG. 9, the main difference between a solar cell 2h and the solar cell 2g is that the light-concentrating element 23e of the solar cell 2h is a refractive type.

### Ninth embodiment

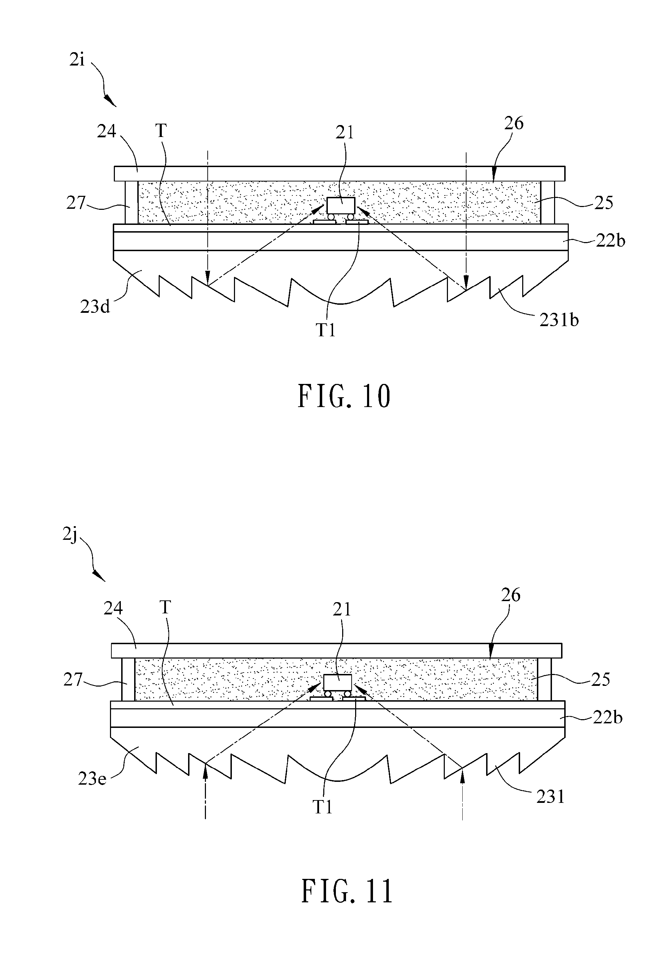

As shown in FIG. 10, the main difference between a solar cell 2i and the solar cell 2g is that the solar cell 2i further includes a substrate 24, a liquid 25, a chamber 26 and a sealing element 27. The technical features of the above elements are explained in the foregoing embodiments, and a detailed description will be omitted herein.

### Tenth embodiment

As shown in FIG. 11, the main difference between a solar cell 2j and the solar cell 2i is that the light-concentrating element 23e of the solar cell 2j is a refractive type.

### Eleventh embodiment

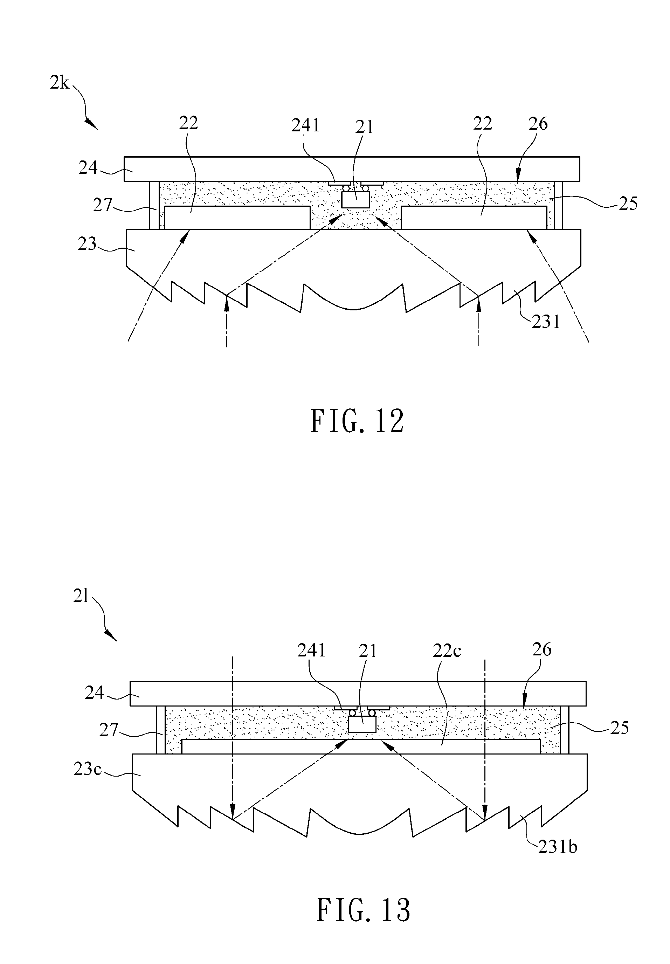

As shown in FIG. 12, the main difference between a solar cell 2k and the solar cell 2d is that the first solar cell element 21 of the solar cell 2k is disposed to the substrate 24, while the second solar cell element 22 is disposed to the light-concentrating element 23. The substrate has a circuit layer 241, and the first solar cell element 21 is electrically connected with the circuit layer 241. When passing through the light-concentrating element 23, a portion of energy of the incident light will be directly absorbed by the second solar cell element 22, and other portion of energy will be concentrated to the first solar cell element 21 through the light-concentrating element 23.

### Twelfth embodiment

As shown in FIG. 13, the main difference between a solar cell 21 and the solar cell 2k is that the second solar cell element 22c of the solar cell 21 is continuous and the light-concentrating element 23c is a reflective type.

### Thirteenth embodiment

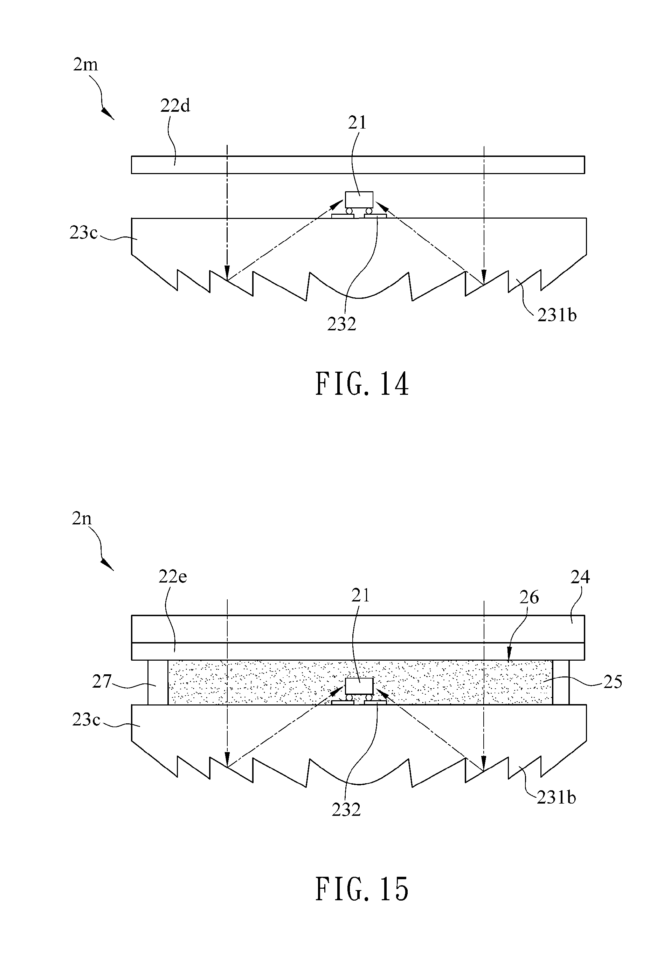

As shown in FIG. 14, the main difference between a solar cell 2m and the solar cell 2a is that the second solar cell element 22d of the solar cell 2m is disposed opposite to the light-concentrating element 23c, and the first solar cell element 21 is disposed between the second solar cell element 22d and the light-concentrating element 23c.

### Fourteenth embodiment

As shown in FIG. 15, the main difference between a solar cell 2n and the solar cell 2m is that the solar cell 2n further has a substrate 24, a liquid 25, a chamber 26 and a sealing element 27. The second solar cell element 22e is formed on the substrate 24, and that is, the substrate 24 does the substrate of the second cell element 22e.

### Fifteenth embodiment

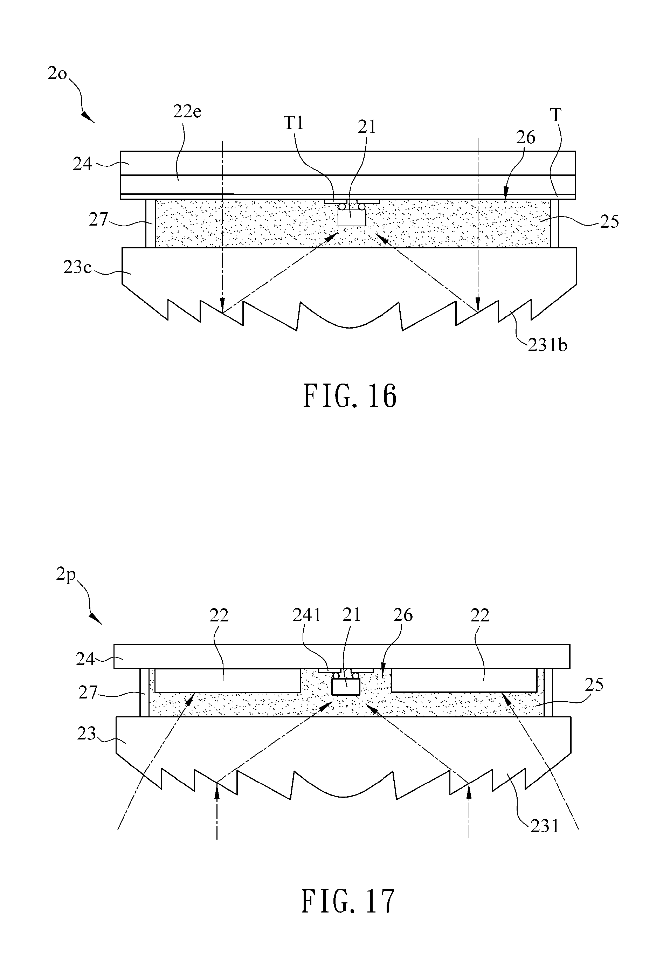

As shown in FIG. 16, the main difference between a solar cell 2o and the solar cell 2n is that the first solar cell element 21 and the second solar cell element 22e are disposed to the substrate 24, and the first solar cell element 21 is disposed to the second solar cell element 22e through a transparent insulating layer T. The transparent insulating layer T has a circuit layer T1, and the first solar cell element 21 is electrically connected with the circuit layer T1.

### Sixteenth embodiment

As shown in FIG. 17, the main difference between a solar cell 2p and the solar cell 2o is that the second solar cell element 22 of the solar cell 2p is disposed around the first solar cell element 21. Besides, the light-concentrating element 23 is a refractive type. Seventeenth embodiment

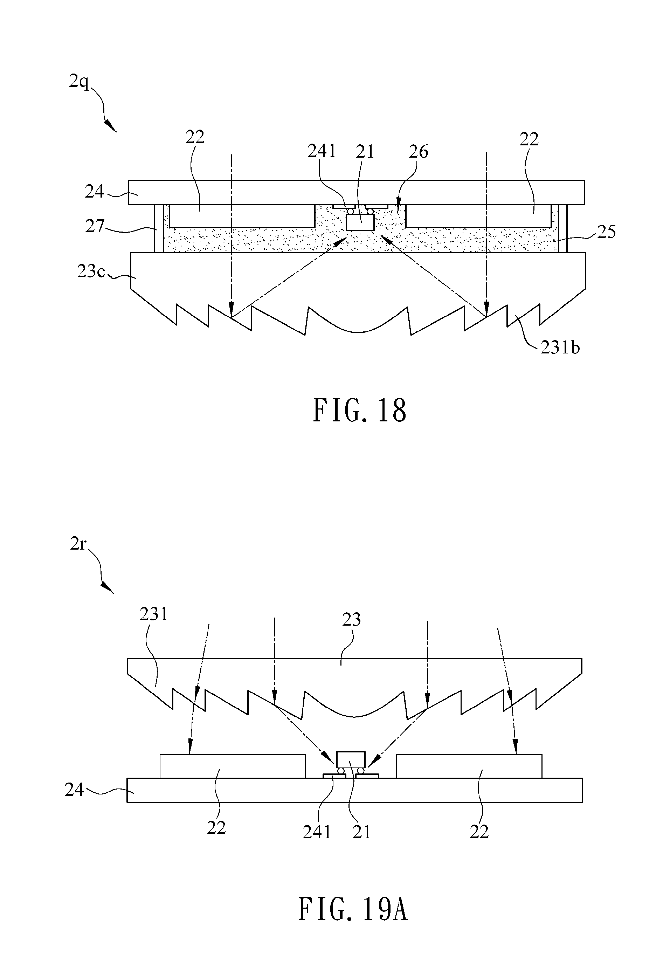

As shown in FIG. 18, the main difference between a solar cell 2q and the solar cell 2p is that the light-concentrating element 23c of the solar cell 2q is a reflective type, and the concentrating structure 231b of which has a reflective layer.

### Eighteenth embodiment

As shown in FIG. 19A, a solar cell 2r according to the eighteenth embodiment of the invention includes a first solar cell element 21, a second solar cell element 22 and a light-concentrating element 23. The area of the first solar cell element 21 is smaller than that of the second solar cell element 22. In the embodiment, the area of the first solar cell element 21 is smaller than half that of the second solar cell element 22.

In the embodiment, the first solar cell element 21 can be disposed on a substrate 24. The first solar cell element 21 can be a die or a package, and is unlimited in shape, such as a square, a circle or a strip. If the first solar cell element 21 is a die, it can be disposed on the substrate 24 by wire bonding and/or flip-chip bonding. If the first solar cell element 21 is a package, it can be disposed on the substrate 24 by SMT (surface mount technology). The first solar cell element 21 is here, for example, a die and flip-chip bonded on the substrate 24. Besides, the first solar cell element 21 can be flip-chip bonded on the substrate 24 by laser welding (laser rays can pass through the substrate 24 before welding). In this case, because wire bonding is not utilized and the hot spot of laser is smaller (for example, its diameter can be 3µm), light-absorption area can be greatly increased and proportion of the light-absorption area can be enlarged as the die is smaller.

The material of the first solar cell element 21 can include mono-crystalline silicon, multi-crystalline silicon, amorphous silicon, micro-crystalline silicon, compound semiconductor or organic material. For example, the first solar cell element 21 can be a mono-crystalline silicon solar cell die, a multi-crystalline silicon solar cell die, an amorphous silicon solar cell die, a III-V solar cell die, a II-VI solar cell die or an organic solar cell die.

The second solar cell element 22 can be disposed adjacent to the first solar cell element 21 or the light-concentrating element 23. In the embodiment, the second solar cell element 22 is disposed adjacent to and around the first solar cell element 21, and disposed to the substrate 24 and disposed on a circuit layer 241 of the substrate 24.

In the embodiment, the second solar cell element 22 is a thin film solar cell. The material of the second solar cell element 22 can include amorphous silicon, compound semiconductor, organic material, micro-crystalline silicon, or poly silicon. The second solar cell element 22 is unlimited in shape, such as a strip, a circle or a loop. In the embodiment, the first solar cell element 21 can be a III-V solar cell die, such as GaAs, CIGS, or CIS (CuInSe), while the second solar cell element 22 can be an amorphous silicon solar cell device made by thin film process. The first solar cell element 21 has a greater photoelectric converting efficiency than the second solar cell element 22.

The light-concentrating element 23 can be a reflective type or a refractive type, and that is, the light can be reflected by or passes through the light-concentrating element 23. The light-concentrating element 23 has a concentrating structure 231 which can have at least a Fresnel structure, at least a lens, a plurality of prisms or a reflective mirror, and the Fresnel structure is illustrated as an example. The amount of the concentrating structure 231 can correspond to that of the first and second solar cell elements 21, 22, and, for example, they can be arranged by one-to-one.

At least one portion of energy of the incident light is concentrated to the first solar cell element 21 through the light-concentrating element 23, while another portion of the energy of the incident light is absorbed by the second solar cell element 22. For example, in good weather condition, most light rays are parallel light, and they can be concentrated to the first solar cell element 21 with a higher photoelectric converting efficiency through the light-concentrating element 23, so as to improve photoelectric converting efficiency of unit area. In bad weather condition, most incident light rays are scattered and thus not easy to be concentrated to the first solar cell element 21, but absorbed by the second solar cell element 22. In addition, a portion of the incident light can also be absorbed by the second solar cell element 22 when the solar tracking system misses the focus. Accordingly, power generation efficiency of the solar cell 2a can be enhanced with prolonged power generation period, and of course, the better effect can be obtained by using a solar tracking apparatus. Furthermore, the concentrated light can not pass through the second solar cell element 22, but be absorbed by the first solar cell element 21, thereby further improving the light usage efficiency and photoelectric converting efficiency.

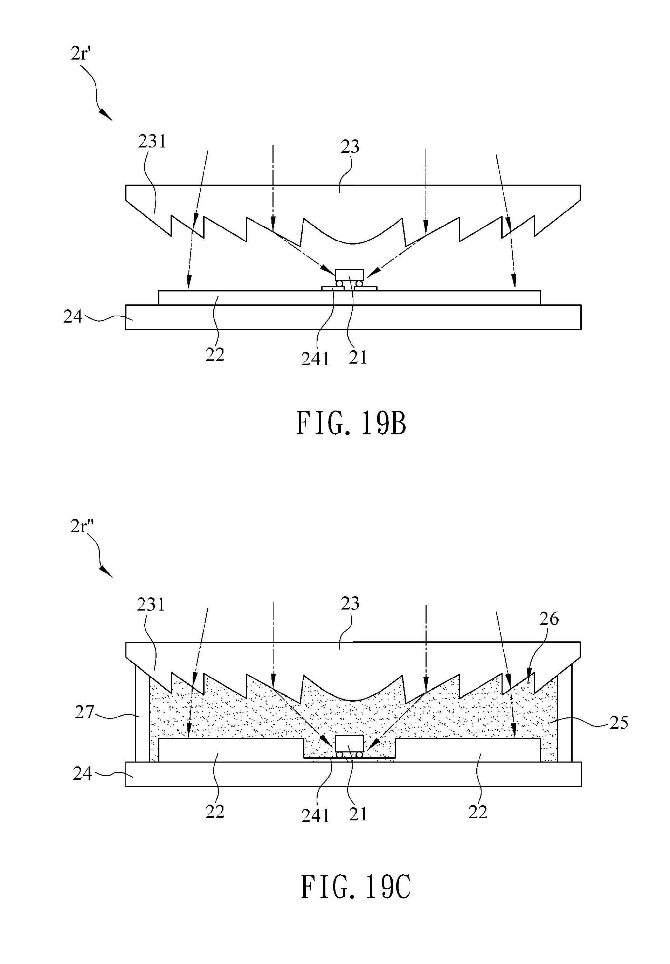

Referring to FIG. 19B, a solar cell 2r' is another aspect of the embodiment. The second solar cell element 22 of the solar cell 2r' is disposed on the substrate 24, and the first solar cell element 21 is directly disposed on the second solar cell element 22. The first solar cell element 21 is electrically connected with a circuit layer 241 disposed on the second solar cell element 22.

As shown in FIG. 19C, the first solar cell element 21 and the second solar cell element 22 of a solar cell 2r" are disposed to the substrate 24. The chamber 26 is formed between the substrate 24 and the concentrating structure 231 of the light-concentrating element 23, and sealed by a sealing element 27 which can be made, for example, of a colloid or a solid with a functionality of insulation. The solar cell 2r" can further have a liquid 25 which is filled in the interval or the chamber 26. The liquid 25 can include high thermal conductive material, such as silicon oil, glycerin or mesitylene (solvent). The refractive index of the liquid 25 can be closer to that of the substrate 24 and the light-concentrating element 23 (for example, the refractive index of glass is about 1.5) to prevent many times of refraction of light. Of course, the liquid 25 can be adopted according to practical situations in consideration of insulating property, corrosion property, solidification point, and thermal expansion coefficient. The liquid 25 can carry great heat produced by the first and second solar cell elements 21, 22, to improve the heat dissipation efficiency and prolong the lifespan of the solar cell 2r".

In the embodiment, the second solar cell element 22 is disposed around the first solar cell element 21. The first solar cell element 21 transmits electric power to the outside by taking advantage of the circuit layer 241 of the second solar cell element 22. For process, a portion of the second solar cell element 22 can be burned away by laser, but at least the circuit layer 241 remains. After applying laser, a depression is formed on the second solar cell element 22, and the first solar cell element 21 can be disposed at the depression and electrically connected with the circuit layer 241 of the second solar cell element 22.

### Nineteenth embodiment

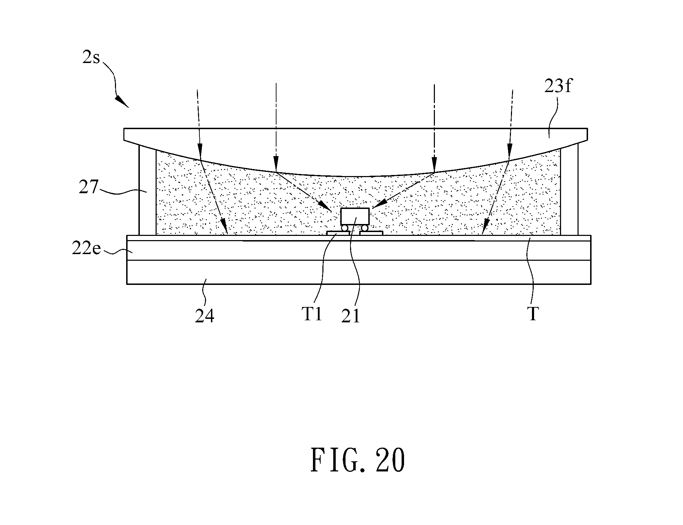

As shown in FIG. 20, the main difference between a solar cell 2s and the solar cell 2r is that the first solar cell element 21 of the solar cell 2s is disposed to the second solar cell element 22e through a transparent insulating layer T. Besides, the light -concentrating element 23f of the embodiment is a lens.

In the invention, the technical features of all the foregoing embodiments can be utilized independently or combined. In addition, the solar cell of the invention can have single first solar cell element and single second solar cell element, or have a plurality of first solar cell elements and second solar cell elements. In the latter case, the first and second solar cell elements can be disposed in the arrangement of a line, a column, two-dimensional array or a matrix.

### Twentieth embodiment

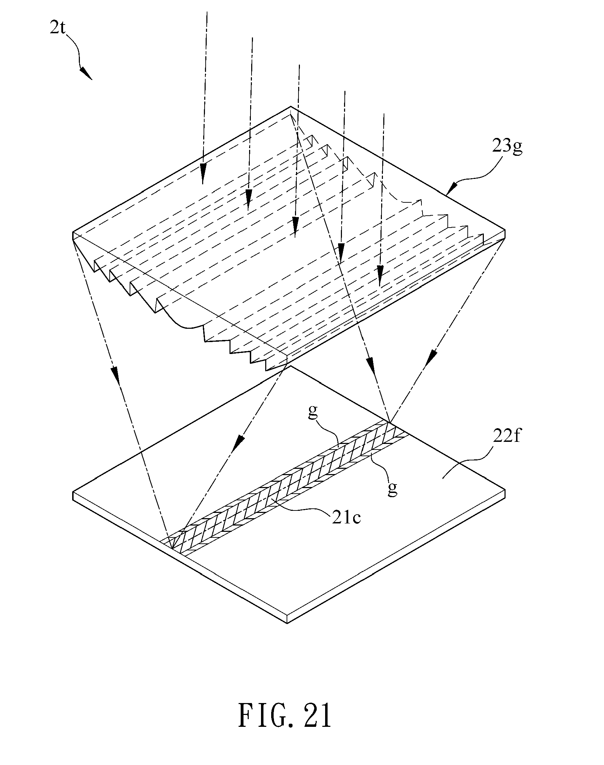

As shown in FIG. 21, a solar cell 2t has a first solar cell element 21c, a second solar cell element 22f and a light-concentrating element 23g. The first solar cell element 21c is strip-shaped, and here it is a linear strip for example. Of course, it also can be a wavy strip, an irregular strip or other types of strip. In the embodiment, the first solar cell element 21c is a multi-crystalline silicon solar cell. The second solar cell element 22f is disposed around the first solar cell element 21 c. In the embodiment, the second solar cell element 22f is an amorphous silicon solar cell.

For process, the first solar cell element 21c can be formed by applying laser annealing to a portion of the second solar cell element 22f. At first, the second solar cell element 22f provided has an amorphous silicon layer. Then, the laser beam is concentrated to a point and moved for laser annealing to the second solar cell element 22f. With various routs of the laser beam, the first solar cell element 21c can be formed in different shapes, such as a curve, a polygon, a circle or an ellipse.

The light-concentrating element 23g is a linear Fresnel lens, concentrating the light to the strip-shaped first solar cell element 21c to improve photoelectric converting efficiency. Besides, the light, which is not concentrated to the first solar cell element 21 c by the light-concentrating element 23g, can be absorbed by the second solar cell element 22f so as to enhance the light usage efficiency.

Furthermore, the solar cell 2t can further include a conductive layer g which here is the so-called metal grid. The difference from the prior art is that, at least a portion of the conductive layer g is overlapped with the second solar cell element 22f. Because the conductive layer g is disposed on the second solar cell element 22f instead of the first solar cell element 21 c, the area of the first solar cell element 21c is retained so that the more light concentrated by the light-concentrating element 23g can be absorbed by the first solar cell element 21c. The conductive layer g transmits the electric power generated by the photoelectric converting of the first solar cell element 21c that is electrically connected with the conductive layer g.

For process, P-type (or N-type) amorphous silicon can be first formed on a surface of a substrate, and then laser annealing is applied to an area in which the solar cell element 21c is to be formed, to transform the amorphous silicon of the area to multi-crystalline silicon. Then, N-type (or P-type) semiconductor layer is formed on the amorphous silicon, and the conductive layer is formed in the certain area. At least a portion of the conductive layer g is disposed at the outside of the first solar cell element 21 c, such as the upper surface of the second solar cell element 22f.

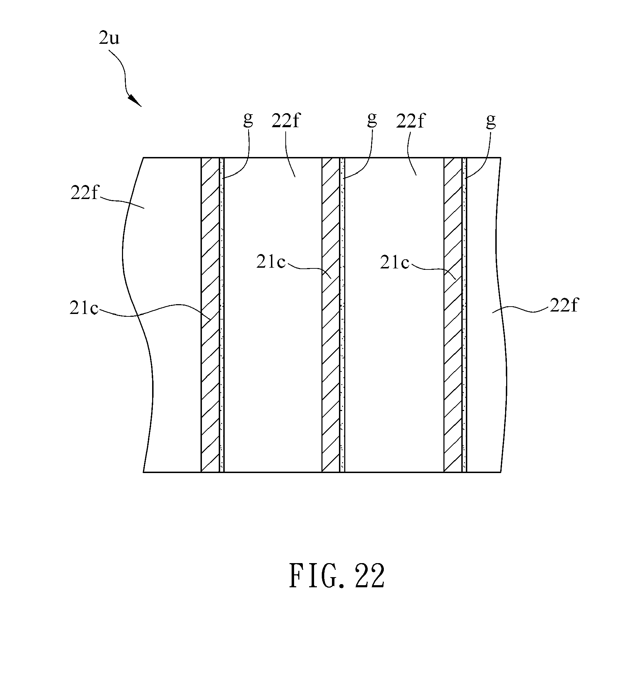

As shown in FIG. 21, the solar cell 2t has single first solar cell element 21c and single second solar cell element 22f. On the other hand, as shown in FIG. 22, the solar cell 2u has a plurality of first solar cell elements 21c and a plurality of second solar cell elements 22f, and the second solar cell elements 22f are disposed at two sides of the first solar cell element 21c. Besides, the conductive layer g of the solar cell 2t is disposed at single side of the first solar cell element 21c and is linearly strip-shaped.

As mentioned above, the solar cell of the invention includes two types of solar cell elements, wherein at least one portion of energy of the incident light is concentrated to the smaller first solar cell element, while another portion of the energy of the incident light can be absorbed by the second solar cell element. In good weather condition, most light rays are parallel light and are thus concentrated to the first solar cell element by the light-concentrating element to obtain higher concentrating effect and photoelectric converting efficiency. In bad weather condition, most light rays are scattered and thus not easy to be concentrated to the first solar cell element after passing through the light-concentrating element, but they can still be absorbed by the larger second solar cell element, thereby improving the photoelectric converting efficiency. In addition, when the first and second solar cell elements are made of different materials, they can absorb the light with different wave bands, thereby enhancing the utility rate of light and photoelectric converting efficiency.

Although the invention has been described with reference to specific embodiments, this description is not meant to be construed in a limiting sense. Various modifications of the disclosed embodiments, as well as alternative embodiments, will be apparent to persons skilled in the art. It is, therefore, contemplated that the appended claims will cover all modifications that fall within the true scope of the invention.

## Claims

1. A solar cell receiving an incident light, comprising:
a first solar cell element;
a second solar cell element, wherein the area of the first solar cell element is smaller than that of the second solar cell element;
a light-concentrating element, wherein the second solar cell element is disposed in neighbor to the first solar cell element or the light-concentrating element, at least one portion of energy of the incident light is concentrated to the first solar cell element through the light-concentrating element, and another portion of the energy of the incident light is absorbed by the second solar cell element.

2. The solar cell as recited in claim 1, wherein the first solar cell element is a die or a package.

3. The solar cell as recited in claim 1, wherein the second solar cell element is a thin film solar cell.

4. The solar cell as recited in claim 1, wherein the first solar cell element and the second solar cell element are made of the same material or different materials.

5. The solar cell as recited in claim 1, wherein the area of the first solar cell element is smaller than half that of the second solar cell element.

6. The solar cell as recited in claim 1, wherein the second solar cell element has a first conductive pattern and a second conductive pattern insulated with each other, the first solar cell element transmits electric power through the first conductive pattern, and the second solar cell element transmits electric power through the second conductive pattern.

7. The solar cell as recited in claim 1, wherein the light-concentrating element has a first surface and an opposite second surface, the first surface has a concentrating structure, and the first solar cell element and the second solar cell element are disposed adjacent to the second surface.

8. The solar cell as recited in claim 7, wherein the first solar cell element and the second solar cell element are disposed at the second surface.

9. The solar cell as recited in claim 8, wherein the second solar cell element is disposed around the first solar cell element.

10. The solar cell as recited in claim 1, further comprising:
a substrate disposed opposite to the light-concentrating element, wherein the first solar cell element and the second solar cell element are disposed between the substrate and the light-concentrating element.

11. The solar cell as recited in claim 10, wherein an interval or a chamber is formed between the substrate and the light-concentrating element.

12. The solar cell as recited in claim 10, wherein the first solar cell element and the second solar cell element are disposed to the substrate.

13. The solar cell as recited in claim 12, wherein the second solar cell element is disposed around the first solar cell element, or the second solar cell element is disposed to the substrate and the first solar cell element is disposed to the second solar cell element through a transparent insulating layer.

14. The solar cell as recited in claim 1, wherein the first solar cell element is strip-like.

15. The solar cell as recited in claim 1, wherein the second solar cell element is disposed around the first solar cell element.
